(19) Europäisches Patentamt
European Patent Office
Office européen des brevets

(11) **EP 4 657 087 A1**

(12) **EUROPEAN PATENT APPLICATION**
published in accordance with Art. 153(4) EPC

(43) Date of publication:
**03.12.2025 Bulletin 2025/49**

(21) Application number: **24747500.7**

(22) Date of filing: **25.01.2024**

(51) International Patent Classification (IPC):
**G01R 29/24** (2006.01)     **H10N 30/30** (2023.01)
**G01R 23/17** (2006.01)     **G01R 1/30** (2006.01)

(52) Cooperative Patent Classification (CPC):
**G01R 1/30; G01R 23/17; G01R 29/24; H10N 30/30**

(86) International application number:
**PCT/KR2024/095053**

(87) International publication number:
**WO 2024/158267 (02.08.2024 Gazette 2024/31)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **25.01.2023  KR 20230009665**
**24.01.2024  KR 20240010611**

(71) Applicant: **LS Cable & System Ltd.**
**Anyang-si, Gyeonggi-do 14119 (KR)**

(72) Inventors:
• **CHO, Young Il**
**Hwaseong-si Gyeonggi-do 18367 (KR)**
• **JUNG, Eui Hwan**
**Gumi-si Gyeongsangbuk-do 39307 (KR)**
• **LEE, Woo Kyoung**
**Suwon-si Gyeonggi-do 16323 (KR)**
• **KIM, Yoon Hyoung**
**Goyang-si Gyeonggi-do 10494 (KR)**
• **KIM, Sun Kak**
**Daejeon 34867 (KR)**

(74) Representative: **K&L Gates LLP**
**Karolinen Karree**
**Karlstraße 12**
**80333 München (DE)**

(54) **LIGHTWEIGHT AND THIN SPACE CHARGE MEASUREMENT DEVICE**

(57)     This space charge measurement device comprises: a sound coupling unit for sensing a sonic vibration generated from a cable to which an electric pulse is applied; a sensor unit for converting, into an electrical signal, the sonic vibration received from the sound coupling unit; a sound delay unit arranged to be adjacent to the sensor unit, and made of a sound absorption material; and an amplification unit for amplifying the electrical signal converted by the sensor unit.

**FIG.2**

EP 4 657 087 A1

**Description**

[Technical Field]

The present disclosure relates to a lightweight and thin space charge measurement device and, more particularly, to a space charge measurement device that can reduce the weight and thickness of an electrode.

[Background Art]

A space charge measurement device converts a pressure wave, generated by a charge in an insulator in response to a high-voltage electric pulse applied from the outside, into an electrical signal through a piezoelectric sensor, and detects it by amplifying the signal through an amplifier. Therefore, one of key technologies is to ensure that the pressure wave generated in a sample reaches a piezoelectric sensor with minimal loss.

A commonly used space charge measurement device is a device using a pulsed electro-acoustic method, and mainly uses aluminum as an electrode that receives a high-voltage pulse and a piezoelectric sensor signal. The aluminum electrode serves either as a ground or an electrode depending on its configuration, and also serves as a sound coupler that transmits the pressure wave generated within a cable to the piezoelectric sensor.

A backing material is attached to ensure that an acoustic wave reaching a piezoelectric element does not reflect off an air layer but continues to propagate. The backing material should have sound impedance that is identical or similar to that of the coupler and the piezoelectric element to prevent a sound wave from being reflected from the piezoelectric element. As such, the space charge measurement device has the electrode for receiving the piezoelectric sensor signal and the backing material, which are disposed in front of and behind the piezoelectric sensor.

The space charge sound signal reaching the piezoelectric sensor passes through the piezoelectric sensor, continues to propagate to the end of the backing material, then is reflected from the end of the air layer with very low impedance and returns back to the sensor. At this time, the thickness of the backing material should be selected so that the returned signal does not enter between or overlap existing signals.

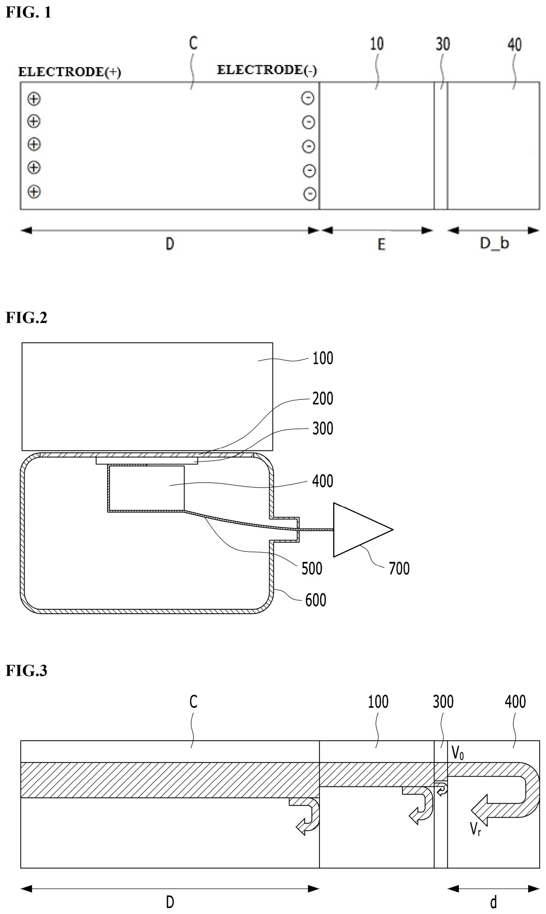

Referring to FIG. 1, when a DC voltage is applied to an insulator C of a cable to be measured, positive (+) and negative (-) charges are formed, respectively, at both ends of the insulator C of the cable to be measured. When the charge generated at each electrode is excited by a pulse, the acoustic wave is propagated toward a piezoelectric sensor 30. The acoustic wave originating from the negative (-) electrode passes through a sound coupling unit 10 and is transmitted to the piezoelectric sensor 30. The acoustic wave originating from the positive (+) electrode passes through the insulator C of the cable to be measured and the sound coupling unit 10 and then reaches the piezoelectric sensor 30. Therefore, the acoustic waves originating from the respective electrodes reach the piezoelectric sensor 30 at different times. Here, a problem is that if the signal of the negative (-) electrode, after passing through the piezoelectric sensor 30, is reflected from the end of the backing material 40 and returns too quickly, it may reach the sensor before the signal from the positive (+) electrode and may mixed with an original signal, making it impossible to accurately measure the space charge. Therefore, in the prior art, the thickness of the backing material 40 is made sufficiently long so that the reflected signal arrives outside a measurement range.

However, when the thickness of the insulator C of the cable to be measured increases, the signal of the positive (+) electrode should travel a longer distance again and consequently arrives later than the reflected wave. In this case, attempting to solve the problem by increasing the thickness of the backing material results in excessive thickness and weight.

If the thickness and sound speed in the backing material are denoted as $D\_b$ and $v\_b$, respectively, the time it takes for the acoustic wave to be reflected and return after passing through the piezoelectric sensor is obtained by dividing a total travel distance by the sound speed. Therefore, since the total travel distance is twice the thickness of the backing material, the time may be expressed as $2 \times D\_b / v\_b$.

Since the arrival time of the reflected wave should be later than the time at which the signal from the positive (+) electrode reaches the piezoelectric sensor, if the thickness of the insulator is D, the thickness of the sound coupling unit is E, and the sound speed is $v\_d$, 'the time at which the positive (+) signal reaches the piezoelectric sensor < the time at which the reflected wave returns to the piezoelectric sensor' should be satisfied, which leads to Equation 1 below.

$$\text{Equation 1}$$

$$(D+E)/(v\_d) < (E/v\_d) + (2*D\_b) / v\_b$$

When Equation 1 is rearranged in terms of the thickness of the backing material, the following Equation 2 may be established.

Equation 2

$$D\_b > D * [(0.5*v\_b) / v\_d]$$

That is, the thickness of the backing material is determined by a ratio of the sound speed of the backing material to the sound speed of the insulator of the cable to be measured.

However, when copper is used as the backing material, the sound speed of copper is approximately 3 to 4 times faster than the sound speed in a sample to be measured. Thus, the thickness of the backing material should be at least twice as great as the thickness of the insulator of the sample to be measured. This undesirably leads to an increase in the size and weight of the space charge measurement device.

[Disclosure]

[Technical Problem]

In view of the above, the present disclosure provides a space charge measurement device that can measure space charge while minimizing the influence of noise and reduce both weight and thickness.

[Technical Solution]

The present disclosure provides a space charge measurement device including a sound coupling unit for sensing a sonic vibration generated from a cable to which an electric pulse is applied, a sensor unit for converting, into an electrical signal, the sonic vibration received from the sound coupling unit, a sound delay unit arranged to be adjacent to the sensor unit and made of a sound absorption material, and an amplification unit for amplifying the electrical signal converted by the sensor unit.

In an embodiment of the present disclosure, a thickness of the sound delay unit may satisfy the following equation:

$$D_b > 13\text{dB} \div (2 \times A_b)$$

(where $A_b$ represents an attenuation rate per sound thickness of the sound delay unit, $D_b$ represents the thickness of the sound delay unit, and 13dB is a minimum target for a sound attenuation rate.)

Preferably, in an embodiment of the present disclosure, the thickness of the sound delay unit may satisfy the following equation:

$$D_b > 20\text{dB} \div (2 \times A_b)$$

(where $A_b$ represents the attenuation rate per sound thickness of the sound delay unit, $D_b$ represents the thickness of the sound delay unit, and 20dB is a minimum target for a sound attenuation rate.)

In an embodiment of the present disclosure, the lightweight and thin space charge measurement device may further include aluminum foil disposed between the sound coupling unit and the sensor unit.

In an embodiment of the present disclosure, the lightweight and thin space charge measurement device may further include an insulating member disposed between the sensor unit and the sound delay unit.

In an embodiment of the present disclosure, the lightweight and thin space charge measurement device may further include a housing disposed to be adjacent to the sound coupling unit and accommodating the sensor unit and the sound delay unit.

In an embodiment of the present disclosure, the sound coupling unit may be formed of a polymer material.

In an embodiment of the present disclosure, the sound delay unit may be formed of a material selected from oak or a glass-epoxy composite.

[Advantageous Effects]

According to the present disclosure, a sound coupling unit of a space charge measurement device is formed of a polymer material, and a sound delay unit is composed of a sound absorption material, thereby minimizing the influence of noise in space charge measurement while also reducing the thickness and weight of the space charge measurement device.

[Description of Drawings]

FIG. 1 is a diagram illustrating a relationship between the thickness of a backing material and the speed of sound.
FIG. 2 is a sectional view showing a space charge measurement device according to an embodiment of the present disclosure.
FIG. 3 is a diagram illustrating a sound attenuation rate of a sound delay unit of the space charge measurement device according to an embodiment of the present disclosure.
FIG. 4 is a sectional view showing a space charge measurement device according to an embodiment of the present disclosure.
FIG. 5 is a diagram showing an overall configuration in which the space charge measurement device according to an embodiment of the present disclosure is used.

[Mode for Disclosure]

Since the present disclosure may be changed in various ways and have various forms, embodiments thereof will be described in detail herein. However, this is not intended to limit the present disclosure to a specific disclosed embodiment, but is to be understood as including all modifications, equivalents, or substitutes that fall within the spirit and scope of the present disclosure. Like reference numerals refer to like components throughout various figures of the present disclosure. It will be understood that, although the terms "first", "second", etc. may be used herein to describe various components, these components should not be limited by these terms.

These terms are only used to distinguish one component from another component. The terms used herein are merely intended to describe particular embodiments and are not intended to limit the present disclosure. Further, the singular forms are intended to include the plural forms as well, unless the context clearly indicates otherwise.

It will be further understood that the terms "comprise", "include", "have", etc. when used in this specification, specify the presence of stated features, integers, steps, operations, components, parts, or combinations thereof but do not preclude the presence or addition of one or more other features, integers, steps, operations, components, parts, or combinations thereof.

Unless otherwise defined, all terms including technical and scientific terms used herein have the same meaning as commonly understood by one of ordinary skill in the art to which the present disclosure belongs. It will be further understood that terms used herein should be interpreted as having a meaning that is consistent with their meaning in the context of this specification and the relevant art and will not be interpreted in an idealized or overly formal sense unless expressly so defined herein.

Hereinafter, the preferred embodiments of the present disclosure will be explained in detail with reference to the accompanying drawings.

FIG. 2 is a sectional view showing a lightweight and thin space charge measurement device according to an embodiment of the present disclosure. FIG. 3 is a diagram illustrating a sound attenuation rate of a sound delay unit of the lightweight and thin space charge measurement device according to an embodiment of the present disclosure.

Referring to FIGS. 2 and 3, the lightweight and thin space charge measurement device according to an embodiment of the present disclosure may include a sound coupling unit 100, aluminum foil 200, a sensor unit 300, a sound delay unit 400, a copper tape 500, a housing 600, and an amplification unit 700.

The sound coupling unit 100 may detect a sonic vibration generated from a cable to which an electric pulse is applied. A pulse generation unit (not shown) may apply an electric pulse to a cable, which is a target for measuring space charge. The pulse generation unit may apply the electric pulse to a conductor through an outer semiconducting layer of the cable or directly apply the electric pulse to a conductor of the cable. The sound coupling unit 100 may detect a sonic vibration generated in the conductor of the cable to which the electric pulse is applied. The sound coupling unit 100 may be formed of a polymer material.

The sensor unit 300 may convert the sonic vibration received from the sound coupling unit 100 into an electrical signal. The sensor unit 300 may be composed of a piezoelectric sensor. The electrical signal converted by the sensor unit 300 may be transmitted through the copper tape 500 to the amplification unit 700. The amplification unit 700 may amplify the electrical signal converted by the sensor unit 300. A surface of the sensor unit 300 may be treated with a thin metal film or conductive paint so that when pressure is generated in the sensor unit 300, the '-' or '+' charge generated on an upper portion of the sensor unit 300 is transmitted through the aluminum foil 200 to the housing 600. The aluminum foil 200 may serve to electrically connect the sensor unit 300 to the housing 600. The -' or '+' charge transmitted to the housing 600 may be connected to ground. The charge of opposite polarity generated on a lower portion of the sensor unit 300 may be transmitted through the copper tape 500 to the amplification unit 700.

The sound delay unit 400 is disposed adjacent to the sensor unit 300 and may be made of a sound absorption material. The sound delay unit 400 may be formed of a material that has a high attenuation rate per sound thickness and a small sound impedance difference from the sound coupling unit 100. An exterior of the sound delay unit 400 may be surrounded by a thin metal film or coated with a conductive polymer for electrical signal transmission.

For example, the sound delay unit 400 may be formed of materials such as oak, cork, or glass-epoxy composite. Measurement results for various materials that may be used as the sound delay unit 400 are shown in Table below.

[Table 1]

| Material | Attenuation rate per sound thickness (in 1MHz) | Sound speed | Density | Sound impedance |
|---|---|---|---|---|
| Acrylic (sound coupler) | 91dB/m | 2,400m/sec | 950kg/m$^3$ | 2.3MPa*s/m |
| Oak | 2,500dB/m | 2,300m/sec | 780kg/m$^3$ | 1.8MPa*s/m |
| Cork | 3,000dB/m | 518m/sec | 160kg/m$^3$ | 83kPa*s/m |
| Glass-epoxy composite | 1,000dB/m | 1,000m/sec | 1,450kg/m$^3$ | 1.45MPa*s/m |

As a result of measuring various candidate materials for the sound delay unit 400, oak, glass-epoxy composite, and cork are found, in that order, to exhibit high attenuation rate per sound thickness while maintaining a small sound impedance difference from the sound coupling unit 100.

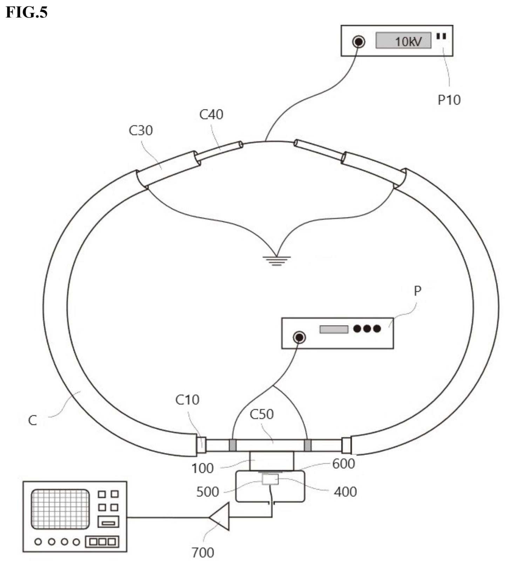

FIG. 5 schematically shows the overall structure of the space charge measurement device. After a shielding layer C10 of the cable C to be measured is removed, the sound coupling unit 100 mechanically contacts an exposed insulation layer C50. While a voltage is applied from a high-voltage generator P10, a high-voltage pulse generator P is electrically connected to the insulation layer C50 of the cable to apply a pulse thereto.

Referring to FIG. 3, when the electric pulse is applied to the cable C to be measured, the sound coupling unit 100 may detect the sonic vibration generated in the conductor of the cable C, and the sensor unit 300 may convert the sonic vibration received from the sound coupling unit 100 into an electrical signal. At this time, the sonic vibration is also transmitted to the sound delay unit 400, and a signal reflected from an end of the sound delay unit 400 reaches the sensor unit again. Since this may affect a sound signal received from the sensor unit 300, the signal reflected back from the end of the sound delay unit 400 should be designed to be below a noise level.

That is, the signal reflected back from the end of the sound delay unit 400 should satisfy the equation defined by Equation 3 below.

Equation 3

$$V_r < \frac{5}{100} \times V_0$$

(where, Vo represents a measurement signal, Vr represents a signal reflected back from the sound delay unit 400, and 5/100 represents a target value for a minimum attenuation rate.)

In FIG. 3, if a total travel distance of the signal incident on the incident surface of the sound delay unit 400, reflected from the end boundary surface of the sound delay unit 400, and returning to the incident surface is denoted as L, the total travel distance L may be defined by Equation 4 below.

Equation 4

$$L = 2 \times D_b$$

Here, if the measurement signal is denoted as Vo and the reflected signal is denoted as Vr, reducing Vr to 5/100 or less of Vo has little effect on an original signal, thereby allowing the space charge to be relatively accurately measured. Therefore, the target attenuation rate of the sound delay unit may be defined by Equation 5 below.

Equation 5

$$\frac{V_r}{V_0} = \frac{5}{100}, \quad 10 \log\frac{V_r}{V_0} = -13$$

Since the attenuation rate $A_b$ per sound thickness of the sound delay unit (unit: dB/m) should be reduced by at least 5/100 compared to the original signal at a point where the reflected signal returns, it should satisfy Equation 6 below (log values are rounded to the second decimal place.)

Equation 6

$$A_b < \frac{\text{target attenuation rate}}{\text{total travel distance}}, \quad A_b < \frac{-13dB}{2 \times D_b},$$

Here, since the '-' sign indicates attenuation, if the '-' is deleted and the direction of the inequality sign is reversed, the thickness of the sound delay unit 400 should satisfy Equation 7 below.

Equation 7

$$D_b > 13dB \div (2 \times A_b)$$

(where, $A_b$ represents the attenuation rate per sound thickness of the sound delay unit, and $D_b$ represents the thickness of the sound delay unit.)

According to the above Equation 4, the minimum attenuation rate per thickness of the sound delay unit 400 may be calculated as shown in Table 2 below.

[Table 2]

| Thickness(mm) | Attenuation rate per minimum sound thickness (dB/m) |
| --- | --- |
| 5 | 2,000 |
| 10 | 1,000 |
| 20 | 500 |

When the sound delay unit 400 is composed of oak, it may be formed with a thickness of 4mm, as the attenuation rate per sound thickness of the oak is 2,500dB/m. When the sound delay unit is composed of glass-epoxy composite, it may be formed with a thickness of 10mm, as the attenuation rate per sound thickness of the glass-epoxy composite is 1,000dB/m.

That is, when the sound delay unit 400 is composed of a sound absorption material such as oak or glass-epoxy composite, the thickness and weight of the sound delay unit 400 may be significantly reduced compared to when it is composed of a copper block or lead.

The housing 600 may accommodate the sensor unit 300 and the sound delay unit 400. The housing 600 may be formed of aluminum material and may perform a shielding function.

Preferably, the signal reflected back from the end of the sound delay unit 400 should satisfy the equation defined by Equation 8 below.

Equation 8

$$V_r < \frac{1}{100} \times V_0$$

(where, Vo represents a measurement signal, Vr represents a signal reflected back from the sound delay unit 400, and 1/100 is a target value for a minimum attenuation rate.)

In FIG. 3, if a total travel distance of the signal incident on the incident surface of the sound delay unit 400, reflected from the end boundary surface of the sound delay unit 400, and returning to the incident surface is denoted as L, the total travel distance L may be defined by Equation 9 below.

Equation 9

$$L = 2 \times D_b$$

Here, if the measurement signal is denoted as Vo and the reflected signal is denoted as Vr, reducing Vr to 1/100 or less of Vo can be seen as having little effect on an original signal. Therefore, the target attenuation rate of the sound delay unit may be defined by Equation 10 below.

Equation 10

$$\frac{V_r}{V_0} = \frac{1}{100}, \quad 10 \log \frac{V_r}{V_0} = -20$$

Since the attenuation rate $A_b$ per sound thickness of the sound delay unit (unit: dB/m) should be reduced by at least 1/100 compared to the original signal at a point where the reflected signal returns, it should satisfy Equation 11 below.

Equation 11

$$A_b < \frac{\text{target attenuation rate}}{\text{total travel distance}}, \quad A_b < \frac{-20dB}{2 \times D_b}$$

Here, since the '-' sign indicates attenuation, if the '-' is deleted and the direction of the inequality sign is reversed, the thickness of the sound delay unit 400 should satisfy Equation 12 below.

Equation 12

$$D_b > 20\text{dB} \div (2 \times A_b)$$

(where, $A_b$ represents the attenuation rate per sound thickness of the sound delay unit, and $D_b$ represents the thickness of the sound delay unit.)

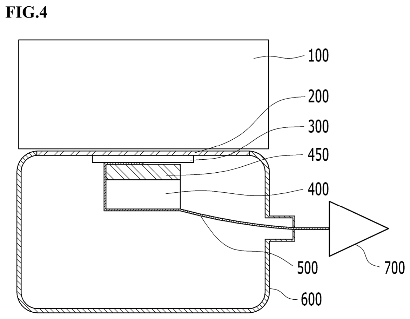

FIG. 4 is a sectional view showing a lightweight and thin space charge measurement device according to an embodiment of the present disclosure.

The lightweight and thin space charge measurement device according to the embodiment of FIG. 4 is substantially the same as the lightweight and thin space charge measurement device of FIG. 2 except for an insulating member 450. Therefore, a duplicated description thereof will be omitted.

Referring to FIG. 4, the lightweight and thin space charge measurement device according to an embodiment of the present disclosure may include a sound coupling unit 100, aluminum foil 200, a sensor unit 300, a sound delay unit 400, an insulating member 450, a copper tape 500, a housing 600, and an amplification unit 700.

In this embodiment, the insulating member 450 may be disposed between the sensor unit 300 and the sound delay unit 400. The sound delay unit 400 needs to press the sensor unit 300 with a certain level of pressure to ensure good contact and allow an electrical signal to be transmitted well. However, if the strength of the sound delay unit 400 is weak, the insulating member 450 may serve to reinforce the strength. As a result, sound characteristics may be improved. Although the insulating member 450 is illustrated as having a rectangular parallelepiped shape, it may be formed in various shapes to reinforce the strength without being limited thereto. In addition, the insulating member 450 may be formed of a material having a small difference in sound impedance from the sound delay unit 400 in order to minimize sound reflection at the boundary surface with the sound delay unit 400.

While the present disclosure has been described above with reference to embodiments, it will be understood by those of ordinary skill in the art that various modifications and changes can be made to the present disclosure without departing from the spirit and scope thereof as defined in the following claims.

**Claims**

1. A space charge measurement device comprising:

   a sound coupling unit for sensing a sonic vibration generated from a cable to which an electric pulse is applied;
   a sensor unit for converting, into an electrical signal, the sonic vibration received from the sound coupling unit;
   a sound delay unit arranged to be adjacent to the sensor unit, and made of a sound absorption material; and
   an amplification unit for amplifying the electrical signal converted by the sensor unit.

2. The space charge measurement device of claim 1, wherein a thickness of the sound delay unit satisfies the following equation:

$$D_b > 13dB \div (2 \times A_b)$$

   (where $A_b$ represents an attenuation rate per sound thickness of the sound delay unit, and $D_b$ represents the thickness of the sound delay unit.)

3. The space charge measurement device of claim 2, wherein the thickness of the sound delay unit satisfies the following equation:

$$D_b > 20dB \div (2 \times A_b)$$

   (where $A_b$ represents the attenuation rate per sound thickness of the sound delay unit, and $D_b$ represents the thickness of the sound delay unit.)

4. The space charge measurement device of claim 1, further comprising:
   aluminum foil disposed between the sound coupling unit and the sensor unit.

5. The space charge measurement device of claim 1, further comprising:
   an insulating member disposed between the sensor unit and the sound delay unit.

6. The space charge measurement device of claim 1, further comprising:
   a housing disposed to be adjacent to the sound coupling unit, and accommodating the sensor unit and the sound delay unit.

7. The space charge measurement device of claim 1, wherein the sound coupling unit is formed of a polymer material.

8. The space charge measurement device of claim 1, wherein the sound delay unit is formed of a material selected from oak or a glass-epoxy composite.

**FIG. 1**

ELECTRODE(+)    C    ELECTRODE(-)    10    30    40

$\oplus$    $\ominus$
$\oplus$    $\ominus$
$\oplus$    $\ominus$
$\oplus$    $\ominus$
$\oplus$    $\ominus$

D    E    D_b

**FIG.2**

100
200
300
400
500    700
600

**FIG.3**

C    100    300    400

$V_0$

$V_r$

D    d

**FIG.4**

**FIG.5**

## INTERNATIONAL SEARCH REPORT

| International application No. |
|---|
| **PCT/KR2024/095053** |

| A. | CLASSIFICATION OF SUBJECT MATTER |
|---|---|

**G01R 29/24**(2006.01)i; **H10N 30/30**(2023.01)i; **G01R 23/17**(2006.01)i; **G01R 1/30**(2006.01)i

According to International Patent Classification (IPC) or to both national classification and IPC

| B. | FIELDS SEARCHED |
|---|---|

Minimum documentation searched (classification system followed by classification symbols)

G01R 29/24(2006.01); G01N 27/92(2006.01); G01R 29/02(2006.01); G01R 29/12(2006.01); G01S 15/931(2020.01); H01B 9/00(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 음파(acoustic wave), 전기적 펄스(electrical pulse), 센서(sensor), 흡음재(sound absorber), 공간전하(space charge)

| C. | DOCUMENTS CONSIDERED TO BE RELEVANT |
|---|---|

| Category* | Citation of document, with indication, where appropriate, of the relevant passages | Relevant to claim No. |
|---|---|---|
| Y | KR 10-2028287 B1 (LS CABLE & SYSTEM LTD.) 02 October 2019 (2019-10-02) See paragraphs [0001]-[0040]; and figures 1a-1b. | 1,4-8 |
| A | | 2-3 |
| Y | KR 10-2022-0071255 A (NIPPON CERAMIC CO., LTD.) 31 May 2022 (2022-05-31) See paragraphs [0030]-[0031]; and figures 1-2. | 1,4-8 |
| Y | JP 2001-051000 A (FUJIKURA LTD.) 23 February 2001 (2001-02-23) See paragraphs [0009]-[0010]; and figure 1. | 7-8 |
| A | KR 10-2021-0102642 A (PARK, June Do) 20 August 2021 (2021-08-20) See claims 1-7; and figures 2-4. | 1-8 |
| A | KR 10-2018-0115459 A (LS CABLE & SYSTEM LTD.) 23 October 2018 (2018-10-23) See figures 2-8. | 1-8 |

☐ Further documents are listed in the continuation of Box C.  ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **23 April 2024** | **24 April 2024** |

| Name and mailing address of the ISA/KR | Authorized officer |
|---|---|
| **Korean Intellectual Property Office** **Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
Information on patent family members

International application No.

**PCT/KR2024/095053**

| Patent document cited in search report | | | Publication date (day/month/year) | Patent family member(s) | | | Publication date (day/month/year) |
|---|---|---|---|---|---|---|---|
| KR | 10-2028287 | B1 | 02 October 2019 | None | | | |
| KR | 10-2022-0071255 | A | 31 May 2022 | CN | 114731474 | A | 08 July 2022 |
| | | | | JP | 2021-072589 | A | 06 May 2021 |
| | | | | JP | 7118041 | B2 | 15 August 2022 |
| | | | | US | 2022-0413137 | A1 | 29 December 2022 |
| | | | | WO | 2021-085598 | A1 | 06 May 2021 |
| JP | 2001-051000 | A | 23 February 2001 | None | | | |
| KR | 10-2021-0102642 | A | 20 August 2021 | KR | 10-2311901 | B1 | 12 October 2021 |
| KR | 10-2018-0115459 | A | 23 October 2018 | KR | 10-2309364 | B1 | 05 October 2021 |

Form PCT/ISA/210 (patent family annex) (July 2022)